# EUROPEAN PATENT SPECIFICATION

(11) **EP 4 365 955 B1**
(45) Date of publication and mention of the grant of the patent: **12.03.2025**
(21) Application number: 22205822.4
(22) Date of filing: 07.11.2022
(51) Int. Cl.: H01L 29/66, H01L 21/8234, H01L 29/417, H01L 21/768, H01L 23/528, H01L 23/535, H01L 23/485

(54) **A METHOD FOR FORMING A SEMICONDUCTOR DEVICE**
VERFAHREN ZUR HERSTELLUNG EINER HALBLEITERVORRICHTUNG
PROCÉDÉ DE FORMATION D'UN DISPOSITIF À SEMI-CONDUCTEUR

(43) Date of publication of application: 08.05.2024
(73) Proprietor: Imec VZW, 3001 Leuven (BE)
(72) Inventor: TAO, Zheng, 3001 Heverlee (BE); CHAN, Boon Teik, 3012 Wilsele (BE)
(74) Representative: AWA Sweden AB

(56) References cited:
- WO-A1-2022/213420
- US-A1- 2017 358 610
- US-A1- 2018 061 868
- US-A1- 2018 233 412
- US-A1- 2019 096 919
- US-A1- 2020 286 926
- US-A1- 2021 028 112
- US-A1- 2021 167 125
- US-A1- 2021 202 634
- US-A1- 2021 335 837
- US-A1- 2022 093 801
- US-A1- 2023 165 056
- US-B1- 10 374 040
- US-B1- 9 947 589

## Description

### Technical field

The present disclosure relates to a method for forming a semiconductor device.

### Background

Advances in microfabrication techniques has allowed a continued scaling of important device parameters of integrated circuits such as line pitch, transistor gate length and contacted poly pitch (CPP), thus enabling circuits with improved device performance and area efficiency.

The self-aligned contact (SAC) process enables CPP scaling as well as an improved overlay (OVL) process window in horizontal channel transistor device fabrication, such as FinFET and nanosheet-FET (NSHFET) device fabrication. A typical conventional SAC process comprises etching source/drain contact openings in an interlayer dielectric, self-aligned to a gate hard mask and gate sidewall spacer. A challenge with the SAC process is however that the etching, while selective to the interlayer dielectric, still may attack the gate hard mask and sidewall spacer, in particular during etching of contact openings with high aspect ratio. Additional challenges include the risk of attack on the epitaxial source/drain bodies and the gate spacer during opening of the contact etch stop layer (CESL) which typically is formed on the source/drain bodies prior to the interlayer dielectric deposition.

US 10374040 B1 discloses a related method in which the source/drain interconnects are initially formed as a continuous layer that is later etched to define discrete structures.

US 2021/028112 A1 discloses a method of fabricating a semiconductor device having a buried buried conductive wiring. The buried conductive wiring and the source/drain regions are contact by filling a contact structure into a via hole in an interlayer insulation layer.

### Summary

In light of the above, it is an objective to provide a method for forming source/drain contacts which overcome or at least mitigate one or more of the afore-mentioned challenges. Further and alternative objectives may be understood from the following.

According to an aspect there is provided a method for forming a semiconductor device according to claim 1.

The present method hence enables self-aligned source/drain contact formation by a direct etching of a metal layer formed over the source/drain bodies. Compared to the mask used for etching the contact trenches in the conventional SAC process, the etching of the metal layer may employ a mask with a reversed or inverse tone.

Typical metals suitable for source/drain contacts (e.g. Ru or Mo) may provide an advantageous etch contrast with respect to both oxide- and nitride-based hard mask and gate spacers.

Additionally, the source/drain bodies may be reliably masked during the etching of the metal layer and the need for a CESL on the source/drain bodies, like in the conventional SAC process, is be obviated. The absence of a CESL additionally allows the source/drain contacts to be formed closer to the channel and with an increased width dimension, to the benefit of the electrical perfermance of the device.

The method is also more robust against loss of gate hard mask and gate spacer, since the cut area (tip to tip area) will be filled with interlayer dielectric (and not metal), which counteracts gate-to-contact shorting.

The term "fin structure" as used herein refers to a fin-shaped structure with a longitudinal dimension oriented in a horizontal direction (e.g. a "first" horizontal direction) along the substrate and protruding vertically therefrom.

Each channel region may comprise at least one channel layer or channel layer portion. Each channel region may comprise a single channel layer integrally formed with the fin structure (wherein the fin structure may be a single fin-shaped semiconductor body). The fin structure may however also comprise one or more horizontally oriented channel layers stacked over a base portion of the fin structure protruding from the substrate.

Relative spatial terms such as "vertical", "upper", "lower", "top", "bottom", "above", "under", "below", are herein to be understood as denoting locations or orientations within a frame of reference of the substrate. In particular, the terms may be understood as locations or orientations along a normal direction to the substrate (i.e. a main plane of extension of the substrate). Correspondingly, terms such as "lateral" and "horizontal" are to be understood as locations or orientations parallel to the substrate (i.e. parallel to the main plane of extension of the substrate).

In some embodiments, forming the metal layer may comprise depositing metal over the device structure to cover and surround the gate structure and the source/drain bodies, and recessing the deposited metal to expose an upper surface of the gate structure.

By the term "recessing" is hereby meant a process adapted to reduce a thickness of the layer or feature being recessed, e.g. the deposited metal. Recessing may comprise polishing and/or etch back (e.g. of the deposited metal). Polishing may comprise chemical mechanical polishing (CMP).

The metal layer may comprise a metal liner sub-layer and a metal fill sub-layer over (e.g. on) the metal liner sub-layer.

In some embodiments, the method may further comprise:
recessing the interlayer dielectric layer to expose an upper surface of the first and second source/drain contacts;
etching back the source/drain contacts to form recessed source/drain contacts; and
forming an insulating contact capping layer on the recessed source/drain contacts.

Source/drain contacts may hence be provided with a desired height and be capped and hence masked prior to subsequent device processing steps.

In some embodiments, the gate structure may comprise a sacrificial gate and the method may further comprise, subsequent to forming the interlayer dielectric, removing the sacrificial gate to form a gate trench and forming a replacement metal gate in the gate trench.

The process steps for the source/drain contact formation may hence be supplemented with replacement metal gate (RMG) processing.

According to the invention, the device structure further comprises a buried wiring line formed in a trench extending alongside the fin structure and capped by an insulating wiring capping layer, wherein the method further comprises: forming a via hole in the wiring capping layer to expose an upper surface of the buried wiring line, and subsequently forming the metal layer, wherein the metal layer fills the via hole and wherein the metal layer is etched such that a first one of the source/drain contacts is formed in contact with the buried wiring line and one of the source/drain bodies.

The direct-metal etch approach of the method is hence applied for interconnecting a buried wiring line and a source/drain body.

Buried wiring lines is a device interconnect which may be used in advanced technology nodes for improved area and power efficiency.
A buried wiring line may be formed in a trench in the substrate, such that the wiring line may be located at a level below the active physical devices. Burying wiring lines enables the cross-section of the wiring lines to be increased (for example reducing the line resistance) without occupying valuable space in the back-end-of-line interconnect structure. Additionally, buried wiring lines may facilitate design of reduced track height standard cells by allowing neighbouring circuit cells to share a common (e.g. increased cross-section) buried wiring line. A buried wiring line and a source/drain body of an adjacent horizontal channel transistor (e.g. a finFET, or a nanosheet- or nanowire-FET) may be interconnected by forming a via-like metal contact extending from the source/drain body and landing on the buried wiring line. One example of a buried wiring line is the buried power rail (BPR). In the case of a BPR, this interconnect is also known as a via-to-BPR (VBPR). The method is however applicable to also other types of buried wiring lines.

Forming a VBPR typically involves etching of a high aspect ratio through interlayer dielectric, liner layers and/or capping layers within narrow contact trenches between gates, with entailing challenges during metal filling. The further aggressive scaling and drive towards high aspect ratio device structures make these issues increasingly challenging.

In contrast, by applying the present direct-metal etch approach to form a source/drain contact in contact with the buried wiring line (e.g. BPR) and one of the source/drain bodies (the first), these challenges may be mitigated. Firstly, a thickness of dielectric material which needs to be opened to expose the buried wiring line may be limited to the thickness of the insulating wiring capping layer, which is sufficiently less than the combined thickness of the interlayer dielectrics, liner layers and capping layers of the conventional approach. Secondly, as a CESL on the source/drain bodies may be omitted, a greater contact interface, and thus lower resistance, between the buried wiring line and the source/drain body is enabled.

In some embodiments, forming the via hole may comprise:
forming a temporary process layer over the source/drain bodies and the wiring capping layer;
etching a via opening in the temporary process layer; and
transferring the via opening in the temporary process layer into the wiring capping layer;
and the method may further comprise removing the temporary process layer prior to forming the metal layer.

Using a temporary process layer to form the via hole may facilitate the via hole formation since the material of the temporary process layer may be selected with regard to its etching and masking properties and with less regard to its suitability as a layer in the final device, e.g. its insulating properties. The temporary process layer may in particular be formed on (in direct contact with) the insulating capping layer and the source/drain bodies.

In some embodiments, the via opening may be formed to be displaced (horizontally) relative the first source/drain body such that the first source/drain body is separated from the via opening by a remaining portion of the temporary process layer.

The temporary process layer may be an organic material layer, such as an organic planarizing layer (e.g. an organic spin-on-layer). An organic / carbon-based material may be etched with a high selectivity to interlayer dielectrics typically used for capping buried wiring lines, and materials used for gate spacers and gate (hardmask) caps.

In some embodiments the device structure comprises a plurality of parallel fin structures, each fin structure comprising a number of pairs of source/drain bodies and a channel region between each pair of source/drain bodies, the device structure further comprising a plurality of parallel gate structures spaced apart by gaps and extending transverse to and across the fin structures such that each channel region is overlapped by a respective one of the gate structures;
wherein the metal layer is formed to fill the gaps between the gate structures and subsequently etched to define source/drain contacts on the source/drain bodies in each gap.

A plurality of source/drain contacts may hence be formed in parallel by directly etching the metal layer in the gaps between the gate structures.

Forming the metal layer may comprise depositing metal over the device structure to completely fill the gaps between the gate structures, and recessing the deposited metal to expose an upper surface of the gate structure.

### Brief description of the drawings

The above, as well as additional objects, features and advantages, may be better understood through the following illustrative and non-limiting detailed description, with reference to the appended drawings. In the drawings like reference numerals will be used for like elements unless stated otherwise.
Figures 1a-d depict a conventional SAC process as a comparative example.
Figures 2a-d depict the conventional SAC process applied to form a VBPR.
Figures 3a-d depict a method for forming a semiconductor device comprising a direct metal etch approach, not in accordance with the claimed invention.
Figures 4a-f and 5 depict a method for forming a source/drain contact interconnected with a buried wiring line comprising the direct metal etch approach, in accordance with the claimed invention.

### Detailed description

Hereinafter follows a detailed description of embodiments of a method for forming a semiconductor device, more specifically for forming source/drain contacts on source/drain bodies of a FET transistor device. The FET transistor device may comprise at least one horizontally oriented channel layer. Examples of applicable FET devices include the finFET device (e.g. wherein each channel region comprises a single fin-shaped channel layer) and the horizontal/lateral nanowire- or nanosheet-channel FET device (e.g. wherein each channel region comprises a number of vertically stacked nanowires or nanosheets).

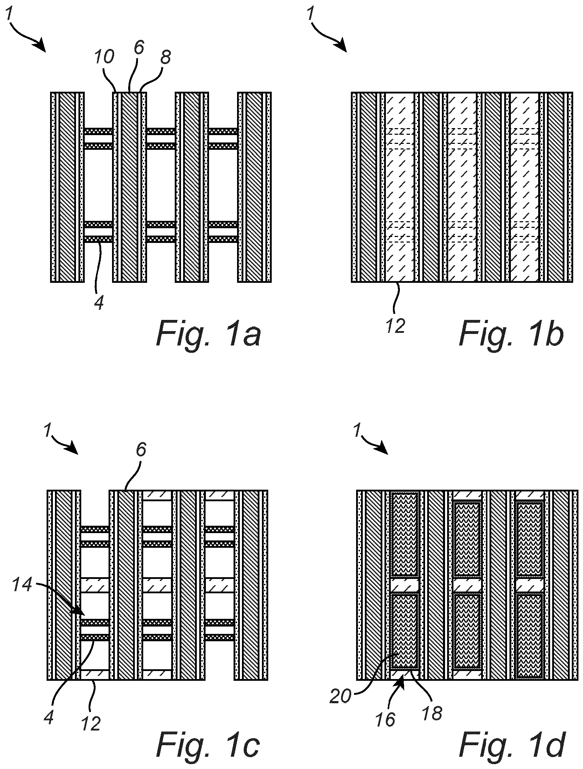

By means of introduction, a brief description of a SAC process will first be provided with reference to Figs. 1a-d as a comparative example.

Fig. 1a schematically depicts a top-down view of a device structure 1 after forming source/drain bodies 4 on semiconductor fins and depositing a CESL 10. Gate structures comprising a gate body 6 and a gate spacer 8 extend across the semiconductor fins. While Fig. 1a schematically shows the CESL 10 only along the gate structures, it is to be noted the CESL 10 may cover also the source/drain bodies 4. In Fig 1b, an ILD 12 has been deposited and planarized, e.g. by chemical mechanical polishing (CMP), to bring the ILD surface planar with an upper surface of the gate structures (e.g. an upper surface of a gate cap/hardmask). In case the gate bodies 6 are sacrificial, RMG processing may then be performed to replace the sacrificial gate bodies with functional gate stacks 6'. In Fig. 1c, source/drain contact trenches 14 have subsequently been patterned in the ILD 12, over the source/drain bodies 4. In Fig. 1d, the trenches 14 have been filled with metal (comprising e.g. metal liner 18 and metal fill 20) which then may be subjected to CMP to complete the source/drain contacts 16 (inset D).

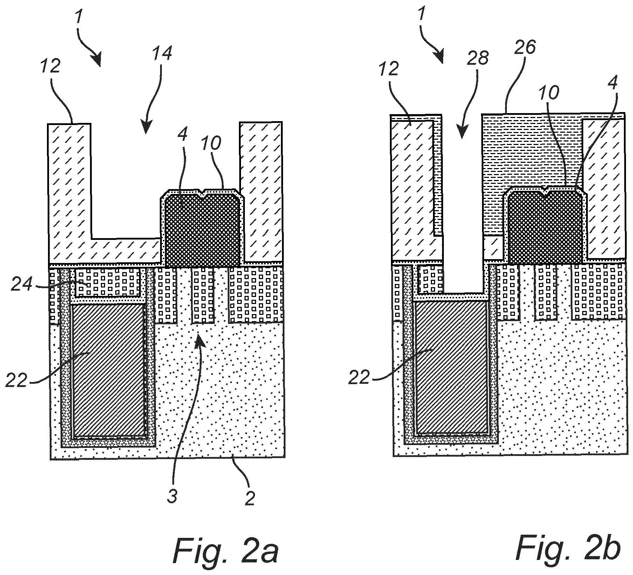

Figs 2a-d further shows the corresponding SAC process in combination with VBPR formation. Fig. 2a schematically depicts a cross-section of the device structure 1 extending through a source/drain body 4 formed on a pair of fin structures 3 protruding from a substrate 2. The device structure 1 comprises a BPR 22 (or more generally a buried wiring line) capped by an insulating capping layer 24. The capping layer 24 and the source/drain body 4 have been covered by CESL 10 and ILD 12. A source/drain contact opening 14 has been formed in the ILD 12 to expose a portion of the CESL 10 on the source/drain body 4, thus corresponding to the stage of the process depicted in Fig. 1c.

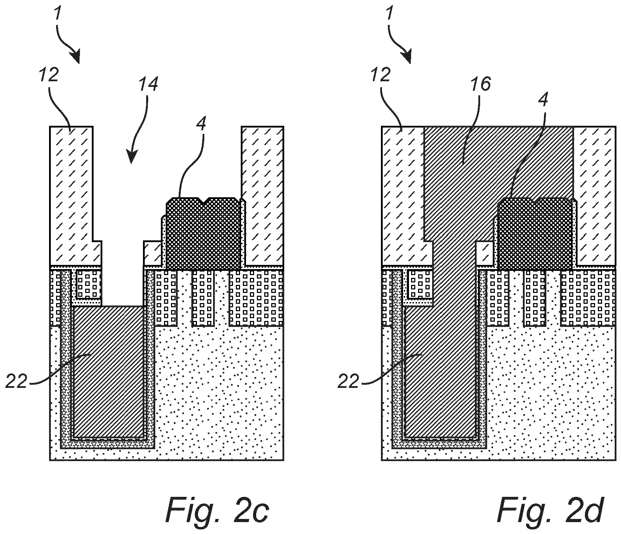

In Fig. 2b, the device structure 1 has been covered by a mask layer 26 (e.g. a photo resist or a lithographic layer stack for instance of spin-on glass and spin-on-carbon) and a via opening 28 has been patterned in the mask layer 26 and subsequently transferred into the capping layer 24, e.g. stopping on the CESL 10. In Fig. 2c, the mask layer 26 has been removed and the CESL 10 has been opened to expose a portion of the BPR 22 and the source/drain body 4 in the source/drain contact opening 14. In Fig. 2d the contact opening 14 has been filled with contact metal (e.g. metal liner 18 and metal fill 20 like in Fig. 1d) to form the source/drain contact 16 and a VBPR interconnecting the source/drain body 4 and the BPR 22.

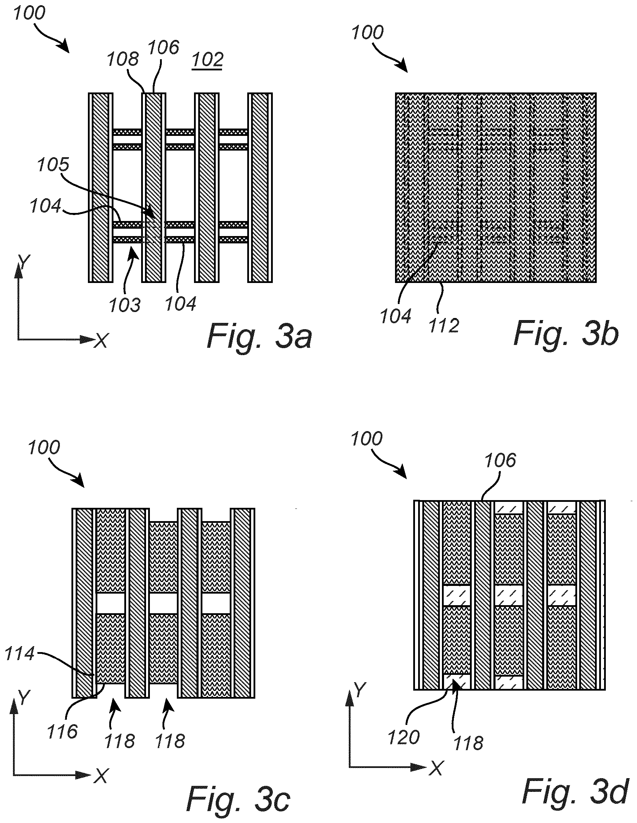

A method for forming a semiconductor device comprising a direct metal etch approach will now be disclosed with reference to Figs. 3a-d, each schematically depicting a top-down view of a device structure 100 at various stages of the method.

With reference to Fig. 3a, the device structure 100 is formed on a substrate 102. The X- and Y-directions indicated in the figures designate first and second horizontal directions, mutually perpendicular to each other and parallel to a main plane of the substrate 102.

The substrate 102 may be a conventional semiconductor substrate suitable for CMOS processing. The substrate 101 may be a single-layered semiconductor substrate, for instance formed by a bulk substrate such as a Si substrate, a germanium (Ge) substrate or a silicon-germanium (SiGe) substrate. A multi-layered / composite substrate is however also possible, such as an epitaxially grown semiconductor layer on a bulk substrate, or a semiconductor-on-insulator (SOI) substrate, such as a Si-on-insulator substrate, a Ge-on-insulator substrate, or a SiGe-on-insulator substrate.

The device structure 100 comprises a number of fin structures 103 extending in parallel in the X-direction. Pairs of source/drain bodies 104 (i.e. source/drain regions) have been formed on the fin structures 103, on either side of respective channel regions 105. The device structure 100 further comprises gate structures 106 extending in the Y-direction across a respective channel region 105.

The fin structures 103 may be formed e.g. by etching trenches in a semiconductor layer of a channel material (e.g. for forming a finFET device), or in a semiconductor layer stack of sacrificial layers of a sacrificial material and channel layers of a channel material, arranged alternatingly with each other (e.g. for forming a nanowire- or nanosheet-channel FET device). After forming the fin structures 103, the fin structures 103 may be surrounded by shallow-trench isolation (STI), e.g. by filling the trenches with insulating material (e.g. an ILD such as SiO₂) and etching back the same to a desired height. Techniques for fin patterning and STI formation are per se well known in the art and will hence not be further discussed herein.

The gate structures 106 may be sacrificial gate structures 106 and may comprise a sacrificial gate or sacrificial gate body formed by depositing a sacrificial gate layer, e.g. of a-Si, and then patterning the sacrificial gate body therein using single- or multiple-patterning techniques, as per se is known in the art. Each gate structure 106 may further be provided with a gate spacer 108 (e.g. an conformally deposited nitride such as SiN deposited by atomic layer deposition, ALD) formed to extend along sidewalls of each sacrificial gate body, and further a gate cap (e.g. of a hard mask material) on top of the sacrificial gate body. Further details of forming sacrificial gate structures is per se well known in the art and will hence not be further discussed herein.

The source/drain bodies 104 may be formed by epitaxy at either side of each gate structure 106 and channel region 105. The source/drain bodies 104 may be doped in accordance with the intended conductivity type of the FET devices to be formed, e.g. using in-situ doping techniques. Each source/drain body 104 may be formed on, i.e. in contact with, the one or more channel layer of a respective fin structure 103. While not shown in Fig. 3a, source/drain bodies 104 on neighboring pairs of fin structures 103 may be formed to merge to form common source/drain bodies.

Prior to the epitaxy, the fin structures 104 may be recessed by etching back the fin structures 104 in a top-down direction (e.g. negative Z) at either side of each sacrificial gate structure, while using the sacrificial gate structure 106 (e.g. with the gate spacer 108 thereon) as an etch mask. Each fin structure 104 may thereby be partitioned into a plurality of fin structure portions, each comprising a channel region 105 comprising one or more channel layer portions preserved in the channel region underneath each sacrificial gate structure 106. The etch back may thus define end surfaces of the (respective) channel layer(s) at either side of each sacrificial gate structure 106 on which the source/drain bodies 104 may be grown. As per se is known in the art, fin recess and source/drain epitaxy may be performed separately for n-type and p-type devices using an additional lithographic mask.

In Fig. 3b, a metal layer 112 has been formed over the source/drain bodies/regions 104 by depositing one or more metals over the device structure 100 to cover and surround the gate structures 106 and the source/drain bodies 104. The metal layer may comprise a stack of a metal liner sub-layer (e.g. TiN) and a metal fill sub-layer on the metal liner sub-layer (e.g. W, Al, Ru, Mo or Co) respectively deposited using e.g. ALD, CVD or physical vapor deposition (PVD). The deposition of metal layer may be preceded by forming a contact silicide on the source/drain bodies 104. Silicide formation may be done using conventional techniques, e.g. by depositing a suitable metal (such as TiN) followed by anneal to trigger silicidation. After anneal, non-silicided metal may be removed by a metal etch (e.g. isotropic, wet or dry).

In Fig. 3c, the metal layer 112 has been recessed (e.g. CMP and/or etched back top-down) to expose an upper surface of the gate structures 106 (e.g. of the gate cap) and subsequently etched to define respective source/drain contacts 118 on the source/drain bodies 104. Each source/drain contact 118 may as shown comprise a remaining portion of metal liner (sub-layer) 114 and metal fill (sub-layer) 116. The source/drain contacts 118 may be formed in a lithography-and-etching process, e.g. comprising forming a lithographic layer stack comprising a resist layer, lithographically defining a contact pattern in the resist layer, and transferring the contact pattern into lower layers of the lithographic layer stack, e.g. comprising a hard mask and optionally further an organic planarizing layer (e.g. spin-on-carbon) and a spin-on-glass layer. The contact pattern may subsequently be transferred into the metal layer 112 to define the source/drain contacts 118. Any suitable conventional combination of etching processes (e.g. wet and/or dry) and etching chemistries may be used to etch the metal layer 112. For example, Ru can be etched using O₂/Cl₂, W can be etched using Cl₂ or SF₆/CF₄, Mo can be etched using O₂/Cl₂ or SF₆/CF₄, Al can be etched using Cl₂/BCl₃, and TiN can be etched using Cl₂ or SF₆.

In Fig. 3d, an ILD layer 120 has been deposited over the gate structures 106 and the source/drain contacts 118, thus embedding the same.

The ILD layer 120 may be formed by a layer of insulating material such as an oxide (e.g. SiO₂ deposited by CVD), but may also be a composite layer structure of two or more insulating layers of different materials such as a dielectric liner (e.g. a nitride such as SiN) followed by a layer of oxide (e.g. SiO₂). The ILD layer 120 may further be subjected to CMP to planarize an upper surface of the ILD layer 120 and expose an upper surface of the source/drain contacts 118 and the gate structures 106.

The source/drain contact formation is then completed and the method may proceed with further processing steps for completing the device structure 100. For example, the method may further comprise etching back the source/drain contacts 118 to form recessed source/drain contacts, and forming an insulating contact capping layer on the recessed source/drain contacts 118. The source/drain contacts 118 may thus be capped with insulating material (e.g. an oxide such as SiO₂ or a nitride such as SiN). The insulating material may be deposited and then planarized, e.g. by CMP.

Additionally, an RMG process may be performed to replace sacrificial gate structures 106 with functional gate stacks in each channel region 105.

An RMG process may proceed in accordance with a conventional flow, comprising removing the sacrificial gate structures 106 (e.g. the gate cap and the sacrificial gate body) by etching, thereby forming gate trenches in the ILD layer 120, extending across and exposing the fin structures 103 in the respective channel regions 105. A functional gate stack may then be deposited in the gate trenches, to overlap the respective channel regions. A gate stack may comprise a gate dielectric layer and a gate metal stack comprising one or more effective a work function metal (WFM) layers and a gate fill metal. The gate dielectric layer may be formed of a conventional a high-k dielectric e.g. HfO₂, HfSiO, LaO, AlO or ZrO. The WFM layer may be formed of one or more effective WFMs (e.g. an n-type WFM such as TiAl or TiAlC and/or a p-type WFM such as TiN or TaN). The gate fill metal may be formed of conventional gate fill metals e.g. W, Al, Co or Ru. The gate dielectric layer and the first WFM may be deposited by ALD. The gate fill metal may for instance be deposited by CVD or PVD. The gate stack may after deposition be recessed using a metal etch-back process to provide the functional gate stacks with a desired vertical dimension and then be covered by a gate cap, e.g. of a nitride such as SiN. The RMG process may be performed at a reduced thermal budget, e.g. 600 °C or below, to limit degradation of the (semiconductor) source/drain body-(metal) contact interface.

As will be appreciated by a skilled person, an overall method for forming a FET device may include additional process steps in dependence on particular type of device that is to be formed. For instance, a method for forming a horizontal/lateral nanowire- or nanosheet-channel FET device (e.g. comprising a number of vertically stacked nanowires or nanosheets) with a wrap-around gate or gate-all-around may additionally comprise a "channel release process". In a channel release process, sacrificial layers arranged alternatingly with channel layers of each fin structure 103 may be removed in the channel regions 105 by etching, within the gate trenches, the sacrificial material selectively to the channel material. Thereby the channel layers may be "released", such that the functional gate stack may be subsequently deposited in each gate trench to surround the channel layers.

Furthermore, to facilitate among the "channel release", process steps may be performed for forming so-called "inner spacers" on end surfaces of the sacrificial layers, after fin recess and prior to source/drain body epitaxy. Inner spacer formation generally comprises, as per se is known in the art, laterally recessing (i.e. etching back along the +X and -X directions) the sacrificial layers from both sides of each sacrificial gate structure 106 using an isotropic etching process selective to the sacrificial material, and filling the recesses with an inner spacer material (e.g. an ALD-deposited oxide, nitride or carbide). Spacer material deposited outside the recesses may be removed by a subsequent etch step. The inner spacers may thus, among others, act as an etch mask for the source/drain bodies 104 during the channel release.

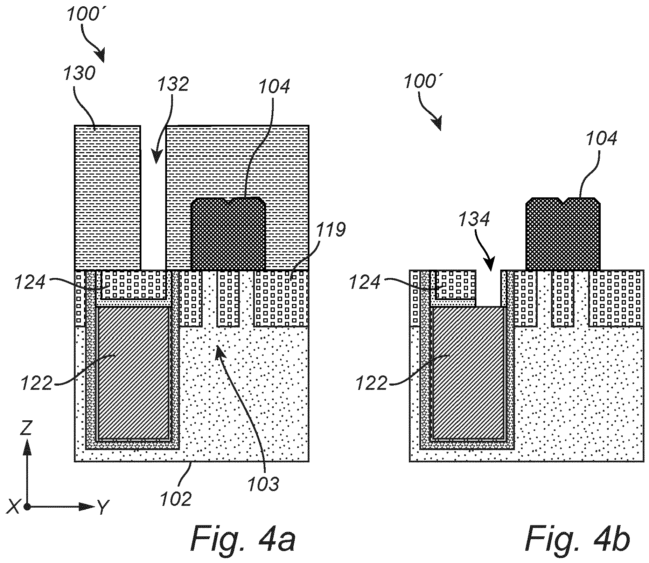

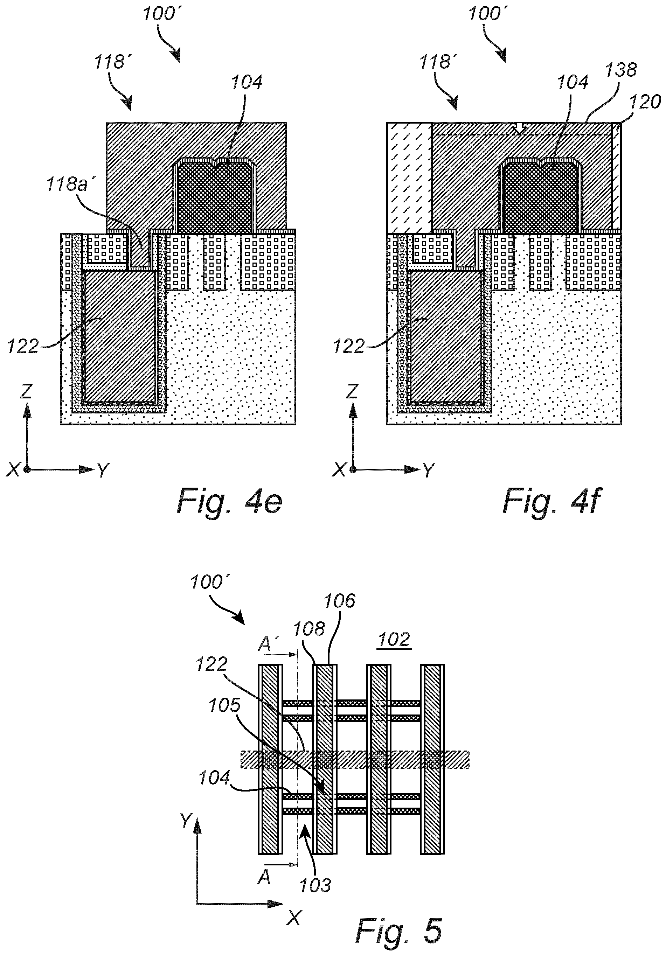

A method using the direct metal etch approach shown in Figs. 3a-d to form a source/drain contact 118' interconnected with a BPR 122 will now be disclosed with reference to Figs. 4a-f and 5. While the illustrated embodiment refers to a buried wiring line in the form of a BPR, it is to noted that the method is applicable to also other types of buried wiring lines, such as buried interconnect lines, buried routing lines, or buried inter-cell signal lines for memory or logic applications.

Figs. 4a-f each schematically depict a cross-section of a device structure 100'. Fig. 5 is a top-down view of the device structure 100' shown in Fig. 4a wherein some elements of Fig. 4a have been omitted for illustrational clarity (e.g. wiring capping layer 124 and process layer 130). The device structure 100' corresponds to the device structure 100 and like references signs refer to like elements and a discussion of those elements will hence not be repeated. The X- and Y-directions indicated in the figures correspond to the X- an Y-directions indicated in Fig. 3a. The Z-direction indicates a vertical direction, normal to a main plane of extension of the substrate 102. The cross-sections are hence parallel to the YZ-plane, and accordingly extend across and transverse to the fin structures 103, e.g. along line A-A'.

The BPR 122 is as shown formed in a trench extending alongside a fin structure 103 in the X-direction. The BPR 122 may be formed by etching the trench through STI 119 (e.g. an oxide such as SiO₂, or another low-k interlayer dielectric material, surrounding a lower portion of the fins 103) and into the substrate 102. The BPR 122 may then be formed in the trench by filling the trench with one or more metals (e.g. a barrier metal and a fill metal) and thereafter etching back the metal to form the BPR 122 with a desired height (along the Z-direction) in the trench. The BPR 122 may then be capped by an insulating wiring capping layer 124 (or insulating layer structure) comprising one or more insulating layers, for instance a nitride liner (e.g. SiN) and an interlayer dielectric (e.g. SiO₂). While in the illustrated embodiment, the BPR 122 is formed with a height such that the BPR 122 protrudes into a lower thickness portion of the STI 119, this is merely an example and it is also possible to form the BPR 122 with a smaller height such that the BPR 122 is embedded only within a thickness portion of the substrate 102.

In the following, reference will mainly be made to a single source/drain body 104, source/drain contact 118' and BPR 122. The following description is however applicable to forming any number of source/drain contacts interconnected with a BPR. For example, additional BPRs may be formed in parallel to the BPR 122 , alongside another fin structure of the device structure 100'.

As further shown in Fig. 4a, a temporary process layer 130 has been formed over the source/drain body 104 and the wiring capping layer 124. The temporary process layer 130 may more specifically cover the source/drain bodies 104 of the device structure 100', and completely fill the gaps between the gate structures 106 (visible in Fig. 5). The temporary process layer 130 may be an organic material layer such as an organic planarizing layer deposited by CVD or by spin-on-deposition (e.g. a spin-on-carbon layer). More generally, the temporary process layer 130 may however be formed by any material facilitating the patterning process to be described below and presenting a sufficient etch contrast with respect to the materials of the wiring capping layer 124.

A via opening 132 has been etched in the process layer 130. The via opening 132 may be formed in a lithography-and-etching process, e.g. comprising lithographically defining a via opening pattern in a resist layer of a lithographic layer stack (omitted from the figures for illustrational clarity) formed over the process layer 130, and transferring the pattern into the process layer 130 to form the via opening 132. The lithographic layer stack may be of a conventional type and comprise a hard mask and a spin-on-glass layer between the resist layer and the process layer 130.

In Fig. 4b the via opening 132 (i.e. pattern of via openings) in the process layer 130 has been subsequently transferred into the wiring capping layer 124 by etching, thereby forming a via hole 134. The etching may be stopped on the upper surface of the BPR 122. The via opening 132 and the via hole 134 may be formed using an anisotropic etching process, for instance a dry etching process such as reactive ion etching (RIE). As may be appreciated, the etching process may comprise a sequence of etch steps with different etching chemistries suitable for etching the different materials of e.g. the temporary process layer 130 and the wiring capping layer 124 (e.g. oxide and/or nitride materials). After forming the via opening 132 the temporary process layer 130 may be removed, e.g. using a suitable etching chemistry.

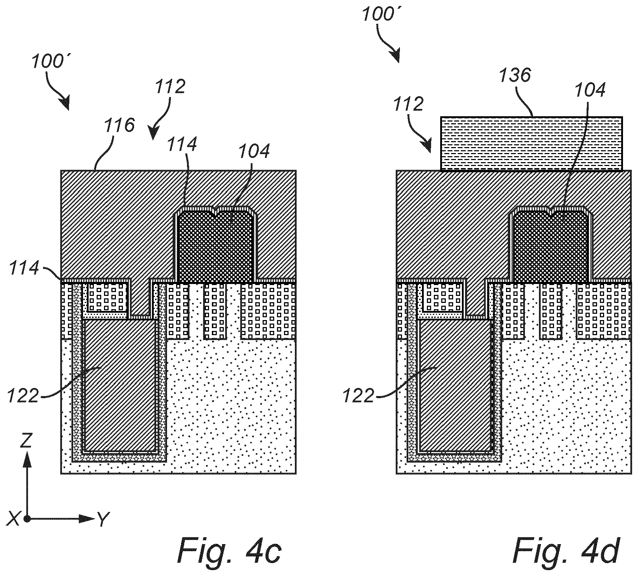

In Fig. 4c a metal layer 112 has been formed over the source/drain body 104 by depositing one or more metals (e.g. a stack of a metal liner sub-layer and a metal fill sub-layer on the metal liner sub-layer) over the device structure 100' to cover and surround the gate structures (e.g. corresponding to the gate structures 106 in Fig. 3a) and the source/drain body 104. The metal layer 112 additionally fills the via hole 134 and is thus formed in contact with the upper surface of the BPR 122. Reference is made to the above discussion of the metal layer 112 in conjunction with Fig. 3b. As discussed in connection with Fig. 3c, the metal layer 112 may further be recessed (e.g. by CMP and/or etched back top-down) to expose an upper surface of the gate structures 106 (e.g. of the gate cap).

In Fig. 4d a mask layer has been formed over the metal layer 112 and patterned to define a contact pattern mask 136. In Fig. 4e, the metal layer 112 has subsequently been etched while using the contact pattern mask 136 as an etch mask to form a source/drain contact 118'. The mask layer and contact pattern mask may be provided in the form of a lithographic layer stack with a composition as discussed above in connection with Fig. 3c. In contrast to the unclaimed example in Fig. 3c, however, the metal layer 112 is (as shown in Fig. 4e) etched such that the source/drain contact 118' is formed in contact with both the BPR 122 and the source/drain body 104. The source/drain contact 118' thus extends from the source/drain body 104 (along the Y-direction) to overlap a position of the BPR 122. The source/drain contact 118' accordingly comprises a VBPR portion 118a' (i.e. a via portion) formed in the via hole 134 and interconnecting the source/drain body 104 and the BPR 122. The interconnection is enabled by patterning the mask layer such that the contact pattern mask 136 (i.e. a continuous pattern portion thereof) overlaps the source/drain body 104 and the via hole 134. As may be appreciated, a corresponding via hole 134 and a corresponding source/drain contact comprising a VBPR portion may be formed at each position of the device structure 100' where a connection between a source/drain body and a BPR is desired. Additionally, a combination of source/drain contacts 118 like in Fig. 3c (i.e. not comprising any VBPR portion) and source/drain contacts 118' like in Fig. 4e (i.e. comprising a VBPR portion 118a') may be patterned simultaneously in the metal layer 112.

In Fig. 4f, an ILD layer 120 has been deposited over the source/drain contact(s) 118' (and any further source/drain contacts) to embed the same. The ILD layer 120 may further be subjected to CMP to planarize an upper surface of the ILD layer 120 and expose an upper surface of the source/drain contact(s) 118' and gate structures. Reference is made to the above discussion of the ILD layer 120 in conjunction with Fig. 3d. As indicated by the dashed horizontal line in Fig. 4f, the method may further comprise etching back the source/drain contact 118' in a top-down direction to form a recessed source/drain contact 118' which may be capped by an insulating contact capping layer 138 (e.g. formed by depositing and then planarizing an oxide such as SiO₂ or a nitride such as SiN).

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming a semiconductor device (100'),
the method comprising:
forming a device structure on a substrate (102), the device structure
comprising a fin structure comprising a pair of source/drain bodies (104) and a channel region between the pair of source/drain bodies, the channel region comprising at least one channel layer, and the device structure further comprising a gate structure extending across the channel region of the fin structure, wherein the device structure further comprises a buried wiring line (122)
formed in a trench extending alongside the fin structure and capped by an insulating wiring capping layer (124);
forming a metal layer (130) over the source/drain bodies; etching the metal layer to define respective source/drain contacts (118') on
the source/drain bodies; and
depositing an interlayer dielectric layer (120) over the gate structure and the source/drain contacts,
wherein the method further comprises forming a via hole (134) in the wiring
capping layer to expose an upper surface of the buried wiring line, and subsequently forming the metal layer, wherein the metal layer fills the via hole and wherein the metal layer is etched such that a first one of the source/drain contacts is formed in contact with the buried wiring line and one of the source/drain bodies.

2. A method according to claim 1, wherein forming the metal layer comprises depositing metal over the device structure to cover and surround the gate structure and the source/drain bodies, and recessing the deposited metal to expose an upper surface of the gate structure.

3. A method according to any one of the preceding claims, wherein the metal layer comprises a metal liner sub-layer (114) and a metal fill sub-layer (116) over the metal liner sub-layer.

4. A method according to any one of the preceding claims, further comprising:
recessing the interlayer dielectric layer to expose an upper surface of the first and second source/drain contacts;
etching back the source/drain contacts to form recessed source/drain contacts; and
forming an insulating contact capping layer (138) on the recessed
source/drain contacts.

5. A method according to any one of the preceding claims, wherein the gate structure comprises a sacrificial gate and the method further comprises, subsequent to forming the interlayer dielectric, removing the sacrificial gate to form a gate trench and forming a replacement metal gate in the gate trench.

6. A method according to any one of the preceding claims, wherein forming the via hole comprises:
forming a temporary process layer (130) over the source/drain bodies and
the wiring capping layer;
etching a via opening (132) in the temporary process layer; and
transferring the via opening in the temporary process layer into the wiring capping layer;
and the method further comprising removing the temporary process layer prior to forming the metal layer.

7. A method according to claim 6, wherein the temporary process layer is an organic material layer.

8. A method according to any one of the preceding claims, wherein the buried wiring line is a buried power rail, BPR.

9. A method according to any one of the preceding claims, wherein the device structure comprises a plurality of parallel fin structures, each fin structure comprising a number of pairs of source/drain bodies and a channel region between each pair of source/drain bodies, the device structure further comprising a plurality of parallel gate structures spaced apart by gaps and extending transverse to and across the fin structures such that each channel region is overlapped by a respective one of the gate structures;
wherein the metal layer is formed to fill the gaps between the gate structures and subsequently etched to define source/drain contacts on the source/drain bodies in each gap.

10. A method according to claim 9, wherein forming the metal layer comprises depositing metal over the device structure to completely fill the gaps between the gate structures, and recessing the deposited metal to expose an upper surface of the gate structure.

## Patentansprüche

1. Verfahren zum Bilden einer Halbleitervorrichtung (100'), wobei das Verfahren umfasst:
Bilden einer Vorrichtungsstruktur auf einem Substrat (102), wobei die Vorrichtungsstruktur eine Finnenstruktur umfasst, die ein Paar von Source-/ Drain-Körpern (104) und eine Kanalregion zwischen dem Paar von Source-/ Drain-Körpern umfasst, wobei die Kanalregion mindestens eine Kanalschicht umfasst, und die Vorrichtungsstruktur ferner eine Gate-Struktur, die sich über die Kanalregion der Finnenstruktur erstreckt, umfasst, wobei die Vorrichtungsstruktur ferner eine vergrabene Verdrahtungsleitung (122) umfasst, die in einem Graben gebildet ist, der sich entlang der Finnenstruktur erstreckt und durch eine isolierende Verdrahtungsdeckschicht (124) abgedeckt ist;
Bilden einer Metallschicht (130) über den Source-/ Drain-Körpern;
Ätzen der Metallschicht, um jeweilige Source-/ Drain-Kontakte (118') an den Source-/ Drain-Körpern zu definieren; und
Abscheiden einer Zwischenschicht-Dielektrikum-Schicht (120) über der Gate-Struktur und den Source-/ Drain-Kontakten,
wobei das Verfahren ferner das Bilden eines Durchgangslochs (134) in der Verdrahtungsdeckschicht, um eine Oberseite der vergrabenen Verdrahtungsleitung freizulegen, und das anschließende Bilden der Metallschicht umfasst, wobei die Metallschicht das Durchgangsloch ausfüllt, und wobei die Metallschicht derart geätzt wird, dass ein erster der Source-/ Drain-Kontakte in Kontakt mit der vergrabenen Verdrahtungsleitung und einem der Source-/ Drain-Körper gebildet wird.

2. Verfahren nach Anspruch 1, wobei das Bilden der Metallschicht das Abscheiden von Metall über der Vorrichtungsstruktur, um die Gate-Struktur und die Source-/ Drain-Körper zu verdecken und zu umgeben, und das Vertiefen des abgeschiedenen Metalls, um eine Oberseite der Gate-Struktur freizulegen, umfasst.

3. Verfahren nach einem der vorhergehenden Ansprüche, wobei die Metallschicht eine metallische Auskleidungsunterschicht (114) und eine metallische Füllunterschicht (116) über der metallischen Auskleidungsunterschicht umfasst.

4. Verfahren nach einem der vorhergehenden Ansprüche, ferner umfassend:
Vertiefen der Zwischenschicht-Dielektrikum-Schicht, um eine Oberseite der ersten und zweiten Source-/ Drain-Kontakte freizulegen;
Rückätzen der Source-/ Drain-Kontakte, um vertiefte Source-/ Drain-Kontakte zu bilden; und
Bilden einer isolierenden Kontaktdeckschicht (138) an den vertieften Source-/ Drain-Kontakten.

5. Verfahren nach einem der vorhergehenden Ansprüche, wobei die Gate-Struktur ein Opfer-Gate umfasst und das Verfahren ferner nach dem Bilden des Zwischenschicht-Dielektrikums das Entfernen des Opfer-Gates, um einen Gate-Graben zu bilden, und das Bilden eines Ersatzmetall-Gates in dem Gate-Graben umfasst.

6. Verfahren nach einem der vorhergehenden Ansprüche, wobei das Bilden des Durchgangslochs umfasst:
Bilden einer vorläufigen Prozessschicht (130) über den Source-/ Drain-Körpern und der Verdrahtungsdeckschicht;
Ätzen einer Durchgangsöffnung (132) in der vorläufigen Prozessschicht; und
Übertragen der Durchgangsöffnung in der vorläufigen Prozessschicht in die Verdrahtungsdeckschicht;
und wobei das Verfahren ferner das Entfernen der vorläufigen Prozessschicht vor dem Bilden der Metallschicht umfasst.

7. Verfahren nach Anspruch 6, wobei die vorläufige Prozessschicht eine organische Materialschicht ist.

8. Verfahren nach einem der vorhergehenden Ansprüche, wobei die vergrabene Verdrahtungsleitung eine vergrabene Stromschiene, BPR, ist.

9. Verfahren nach einem der vorhergehenden Ansprüche, wobei die Vorrichtungsstruktur eine Vielzahl von parallelen Finnenstrukturen umfasst, wobei jede Finnenstruktur eine Anzahl von Paaren von Source-/ Drain-Körpern und eine Kanalregion zwischen jedem Paar von Source-/ Drain-Körpern umfasst, wobei die Vorrichtungsstruktur ferner eine Vielzahl von parallelen Gate-Strukturen umfasst, die durch Lücken beabstandet sind und sich quer und über die Finnenstrukturen erstrecken, so dass sich jede Kanalregion mit einer jeweiligen der Gate-Strukturen überlappt;
wobei die Metallschicht gebildet ist, um die Lücken zwischen den Gate-Strukturen auszufüllen, und anschließend geätzt wird, um Source-/ Drain-Kontakte an den Source-/ Drain-Körpern in jeder Lücke zu bilden.

10. Verfahren nach Anspruch 9, wobei das Bilden der Metallschicht das Abscheiden von Metall über der Vorrichtungsstruktur, um die Lücken zwischen den Gate-Strukturen vollständig auszufüllen, und das Vertiefen des abgeschiedenen Metalls, um eine Oberseite der Gate-Struktur freizulegen, umfasst.

## Revendications

1. Procédé de formation d'un dispositif semi-conducteur (100'), le procédé comprenant :
la formation d'une structure de dispositif sur un substrat (102), la structure de dispositif comprenant une structure à ailettes comprenant une paire de corps de source/drain (104) et une région de canal entre la paire de corps de source/drain, la région de canal comprenant au moins une couche de canal et la structure de dispositif comprenant en outre une structure de grille s'étendant à travers la région de canal de la structure à ailettes, dans lequel la structure de dispositif comprenant en outre une ligne de câblage enterrée (122) formée dans une tranchée s'étendant le long de la structure à ailettes et recouverte par une couche de recouvrement de câblage isolante (124) ;
la formation d'une couche métallique (130) sur les corps de source/drain;
la gravure de la couche métallique pour définir des contacts de source/drain respectifs (118') sur les corps de source/drain ; et
le dépôt d'une couche diélectrique intercalaire (120) sur la structure de grille et les contacts de source/drain,
dans lequel le procédé comprend en outre la formation d'un trou d'interconnexion (134) dans la couche de recouvrement de câblage pour exposer une surface supérieure de la ligne de câblage enterrée, et la formation ultérieure de la couche métallique,dans lequel la couche métallique remplit le trou d'interconnexion et dans lequel la couche métallique est gravée de telle sorte qu'un premier des contacts de source/drain soit formé en contact avec la ligne de câblage enterrée et un des corps de source/drain.

2. Procédé selon la revendication 1, dans lequel la formation de la couche métallique comprend le dépôt de métal sur la structure du dispositif pour couvrir et entourer la structure de grille et les corps de source/drain et l'évidement du métal déposé pour exposer une surface supérieure de la structure de grille.

3. Procédé selon une quelconque des revendications précédentes, dans lequel la couche métallique comprend une sous-couche de revêtement métallique (114) et une sous-couche de remplissage métallique (116) sur la sous-couche de revêtement métallique.

4. Procédé selon une quelconque des revendications précédentes, comprenant en outre :
l'évidement de la couche diélectrique intercalaire pour exposer une surface supérieure des premier et second contacts de source/drain ;
la gravure des contacts de source/drain pour former des contacts de source/drain évidés; et
la formation d'une couche de recouvrement de contact isolante (138) sur les contacts de source/drainévidés.

5. Procédé selon une quelconque des revendications précédentes, dans lequel la structure de grille comprend une grille sacrificielle et le procédé comprend en outre, après la formation du diélectrique intercalaire, le retrait de la grille sacrificielle pour former une tranchée de grille et la formation d'une grille métallique de remplacement dans la tranchée de grille.

6. Procédé selon une quelconque des revendications précédentes, dans lequel la formation du trou d'interconnexion comprend :
la formation d'une couche de traitement temporaire (130) sur les corps de source/drain et la couche de recouvrement de câblage ;
la gravure d'une ouverture de trou d'interconnexion (132) dans la couche de traitement temporaire ; et
le transfert du trou d'interconnexion dans la couche de traitement temporaire dans la couche de recouvrement de câblage ;
et le procédé comprenant en outre le retrait de la couche de traitement temporaire avant la formation de la couche métallique.

7. Procédé selon la revendication 6, dans lequel la couche de traitement temporaire est une couche de matériau organique.

8. Procédé selon une quelconque des revendications précédentes, dans lequel la ligne de câblage enterrée est un rail d'alimentation enterré, BPR.

9. Procédé selon lune quelconque des revendications précédentes, dans lequel la structure du dispositif comprend une pluralité de structures d'ailettes parallèles, chaque structure d'ailette comprenant un certain nombre de paires de corps de source/drain et une région de canal entre chaque paire de corps de source/drain, la structure du dispositif comprenant en outre une pluralité de structures de grille parallèles espacées par des interstices et s'étendant transversalement aux structures d'ailettes et à travers celles-ci de telle sorte que chaque région de canal soit recouverte par une structure de grille respective des structures de grille ;
dans lequel la couche métallique est formée pour remplir les interstices entre les structures de grille et est ensuite gravée pour définir des contacts de source/drain sur les corps de source/drain dans chaque interstice.

10. Procédé selon la revendication 9, dans lequel la formation de la couche métallique comprend le dépôt de métal sur la structure du dispositif pour remplir complètement les interstices entre les structures de grille et l'évidement du métal déposé pour exposer une surface supérieure de la structure de grille.
